# EUROPEAN PATENT SPECIFICATION

(11) **EP 4 416 450 B1**
(45) Date of publication and mention of the grant of the patent: **20.11.2024**
(21) Application number: 23706850.7
(22) Date of filing: 01.02.2023
(51) Int. Cl.: F28F 3/12, F28F 3/04, F28F 13/18, H05K 7/20, B23K 26/00, B23K 26/352, B23K 26/364, B21D 53/02, B23P 15/26, B23C 3/13, B23C 3/30, B81C 1/00

(54) **IMPROVED MICROCHANNEL EVAPORATOR**
VERBESSERTER MIKROKANAL-VERDAMPFER
EVAPORATEUR À MICROCANAUX AMÉLIORÉ

(30) Priority: 04.02.2022 IT 202200002054
(43) Date of publication of application: 21.08.2024
(73) Proprietor: Wieland Provides S.r.l., 04100 Latina (LT) (IT)
(72) Inventor: PROVENZIANI, Franco, 04100 Latina (LT) (IT); CATALDO, Filippo, 04100 Latina (LT) (IT)
(74) Representative: Papa, Elisabetta
(86) International application number: PCT/IB2023/050864
(87) International publication number: WO 2023/148624

(56) References cited:
- EP-A1- 1 811 257
- CN-A- 108 225 079
- US-A1- 2006 226 539
- US-A1- 2017 250 122

## Description

### Technical field of the invention

The present invention relates to a method of manufacturing a microchannel evaporator configured for cooling down electronic components and operating with biphasic fluid, and to a so-implemented evaporator.

In particular, the present invention relates to a method of manufacturing a microchannel evaporator through selected surface treatments which allow to obtain an improved effectiveness of the heat exchange. More specifically, the present invention relates to a method as defined in the preamble of claim 1, and as Ilustrated in CN108225079, and to an evaporator obtained by this method.

### Background

Over the last years an increasing attention has been dedicated to miniaturization of components, especially in the electronics field. The electronic devices and apparatuses, in fact, typically have available reduced areas to dissipate the generated heat and for this they generally produce very high heat flows. Therefore, considerably compact and effective cooling solutions are required.

The microchannel heat exchangers, or evaporators, operating with a biphasic fluid flow (liquid and vapour) represent an optimum solution to the high thermal flow cooling problem. Such type of exchangers can couple high-density heat exchange areas with a high coefficient of heat exchange.

However, the high-density heat transfer areas are difficult and expensive to be manufactured in large quantities. Moreover, it is complex to design passive cooling devices (such as radiators or pulsing heat tubes) for very high heat flows due to the relatively high pressure drops which occur inside the microchannels and which reduce the mass flow rate of the coolant fluid.

Within the cooling systems, then, the need is felt for providing solutions which improve the effectiveness of the heat exchange in heat dissipation devices operating with biphasic flow, while keeping down the production costs and keeping extremely compact the overall dimensions which are required in the electronic applications.

### Summary of the invention

The technical problem placed and solved by the present invention then is to provide a method for manufacturing a heat exchanger of the microchannel type, in particular an evaporator, allowing to obviate one or more of the drawbacks mentioned above with reference to the known art.

Such problem is solved by a manufacturing method according to claim 1. The invention further relates to a heat exchanger of the microchannel type, in particular to an evaporator, obtained with the above-mentioned manufacturing method.

Preferred features of the present invention are set forth in the depending claims.

In the present context, the term "microchannels" associated to the expression "heat exchanger" or "evaporator" identifies a type of heat exchanger known to the person skilled in the art of the heat exchangers, that is an exchanger wherein, in use, the thermal carrier, in particular biphasic, fluid crossing the heat exchange region, results to be confined in paths having hydraulic diameter of the order of millimetre or lower.

Additionally, in the present context, the term "wettability" relates to a property of a solid surface influencing the degree of hydrophilicity and/or the degree of hydrophobicity of the same surface and it is function of the contact angle formed between said surface and a static drop (liquid) in a stagnant environment (vapour). Typically, when the contact angle decreases, a condition is detected wherein the solid surface is more wettable (hydrophilicity) with respect to a condition wherein the solid surface forms with the drop a higher contact angle (hydrophobicity).

The manufacturing method of the present invention allows to implement a heat exchange device, in particular a microchannel evaporator configured to operate with a biphasic fluid and suitable for cooling down electronic components, which offers improved performances in terms of heat exchange effectiveness.

According to the invention a first plate-like body, comprising a coupling face, and a second plate-like body, comprising an inlet and an outlet for the biphasic cooling fluid in/from the evaporator, are provided. On said coupling face, then, a plurality of grooves are formed so as to put in fluid communication said inlet and said outlet. The method, then, provides to form incisions on the inner surface of one or more grooves by laser engraving means. Subsequently, the second plate-like body is overlapped and sealingly coupled to said coupling face in such a way that a respective flow channel - or microchannel - for the biphasic cooling fluid is defined at each groove.

In substance, the manufacturing method according to the invention provides a surface treatment of the evaporator microchannels allowing to improve the heat transfer when a biphasic flow of a coolant fluid is used.

Such surface treatment, as it will be illustrated in details hereinafter even in association to experimental data provided to support the advantageous technical effects obtainable with the invention, aims at modifying the surface wettability of the flow channels of the biphasic flow and influences significantly the heat transfer during the phase change of the latter.

In other terms, it will be appreciated that the method of the invention provides to form incisions in the fluid flow channels which cause a modification of the surface "roughness" selectively and to obtain a degree of wettability of the channels themselves optimized in function of the operating conditions thereupon the evaporator is intended to operate.

This advantageously allows to improve the heat transfer between the electronic component to be cooled down and the coolant fluid crossing the evaporator, without influencing significantly the load losses, by limiting the flow instabilities and moving away the risk of drying phenomena (lack of boiling) at much higher heat flow values with respect to the limit values reached with the cooling devices implemented according to the known methods.

Advantageously, moreover, the use of laser means to form the incisions represents a quicker and more convenient process with respect to different processing types, generally known in different technical fields to obtain surface treatments, such as for example *etching,* deposition, metal foams and sintering.

Moreover, most heat transfer effectiveness obtainable with an evaporator implemented according to the present method allows to decrease the required number of microchannels to be implemented on the plate-like body (the heat exchange surface being equal) and to further decrease the production costs.

Advantageously, it is then possible to obtain an effective solution through a simple, convenient manufacturing process, which meets the constraints placed by the reduced overall dimensions required in the cooling applications in the electronics field.

Other advantages, features and use modes of the present invention will result evident from the following detailed description of some embodiments, shown by way of example and not for limiting purposes.

### Brief description of figures

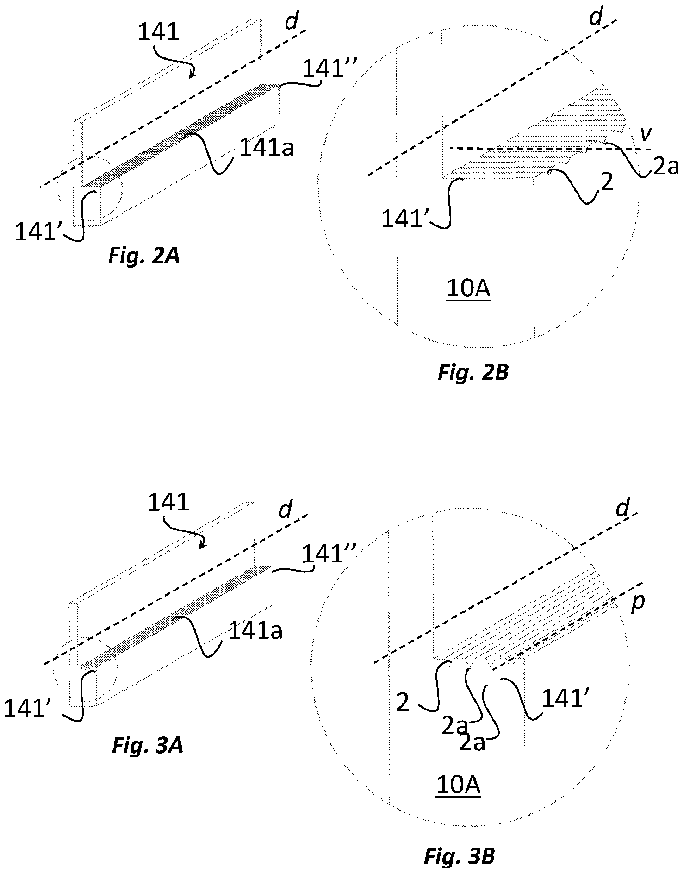

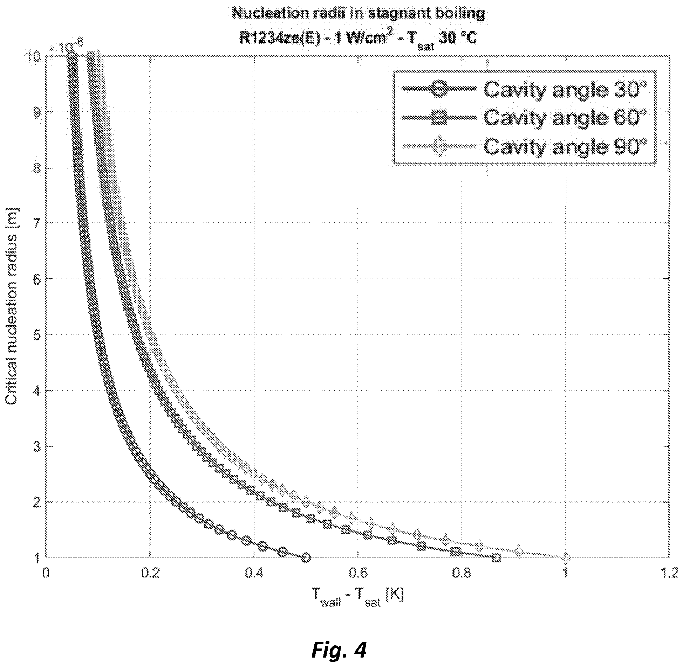

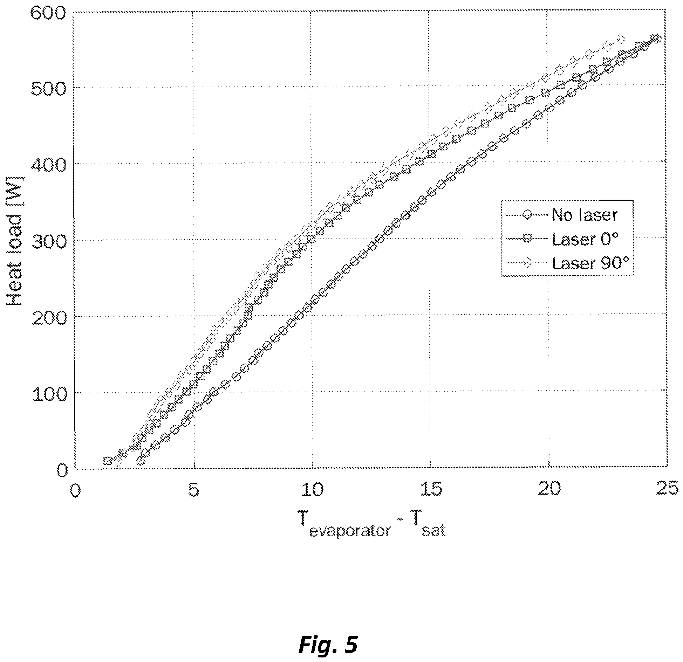

The figures of the enclosed drawings will be referred to, wherein:
▪ Figures 1 and 1A show schematic, respectively top and cross-section, views of an exemplifying embodiment of an evaporator obtained with the method according to the present invention;
▪ Figures 1B and 1C show a top view and a corresponding cross-section view, respectively, of a component of the evaporator illustrated in Figures 1 and 1A;
▪ Figures 2A and 2B show a partial schematic view of a flow channel portion and an enlarged view of a detail of Figure 2A, respectively, obtained according to a first embodiment of the present invention;
▪ Figures 3A and 3B show a partial schematic view of a flow channel portion and an enlarged view of a detail of Figure 3A, respectively, obtained according to a second embodiment of the present invention;
▪ Figure 4 shows a course graph of the boiling critical radius of the nucleate for a cooling fluid used in the evaporator in function of the temperature difference between the wall of a flow channel of the latter and said fluid;
▪ Figure 5 shows a course graph for three boiling curves of the cooling fluid crossing the evaporator in flow channels with different surface treatments and obtained in function of the temperature difference between the evaporator and said fluid.

### Detailed description of preferred embodiments

By firstly referring to Figure 1, 1A-1C a preferred embodiment of a heat exchanger manufactured according to the method of the present invention is shown. Said exchanger is designated as a whole with reference 100.

The exchanger 100 is a heat exchanger of the so-called "microchannel" type and it is suitable to be used in association with electronic systems such as for example processing unit, power electronics and data centres.

In particular, the heat exchanger 100 is used as evaporator and it results to be suitable to cool down electronic components or however to be used in cooling apparatuses of electronic systems, such as for example cooling apparatuses of refrigerator type.

The heat exchanger - or evaporator - 100 comprises a main body 10 having a substantially plate-like overall dimension. An external surface 11 of the main body 10 is provided for coupling with the (not shown) electronic component to be cooled down.

Preferably, said external surface 11 is planar and the main body 10 has a substantially quadrilateral geometry. Said external surface 11 can be coupled thermally with the electronic component through an interface material, for example thermal paste or pads.

The main body 10 can include anchoring means, for example projections designated in Figures 1, 1A-1C with reference 15, to fasten, even removably, with the electronic component to be cooled down.

In order to manufacture the evaporator 100, the method of the invention provides supplying a first plate-like body and a second plate-like body (or covering element) designated in the embodiment example illustrated in Figures, with reference 10A and 10B, respectively. Said first and second plate-like body preferably are made of metallic material, preferably aluminium.

The covering element 10B has an inlet 10' and an outlet 10" for a biphasic cooling fluid in/from the evaporator 100. As first body 10A and covering element 10B assembled therebetween, the inlet 10' preferably is in fluid communication with an inlet manifold 12 suitable to receive the biphasic cooling fluid and the outlet 10" preferably is in fluid communication with an outlet manifold 13 for said fluid downstream of the heat exchange.

The cooling fluid used for the exchanger 100, preferably, is of the type commercially designated R1234ze(E) or R1233zd(E). Both of them are very low GWP fluids and are suitable to boil at normal temperatures.

The covering element 10B can have an additional opening 10‴ for (re)charging the cooling fluid inside the exchanger 100.

In the illustrated example, the inlet 12 and outlet 13 manifolds are obtained in the first plate-like body 10A and in fluid communication therebetween through a heat exchange chamber 14 positioned at the above-mentioned external surface 11 intended to the contact with the device to be cooled down. Said external surface 11 preferably extends for a width at least equal to the planar extension of the heat exchange chamber 14.

Advantageously, the heat exchange chamber 14 results to be interposed between the inlet manifold 12 and the outlet manifold 13. Such solution offers advantages in terms of reduced vertical overall dimensions of the exchanger 100.

The heat exchange chamber 14 is inside the evaporator 100. In particular, the heat exchange chamber 14 is defined at a plurality of grooves 141 which are formed on a coupling face 101 of the first plate-like body 10A and so as to put in fluid communication the above-mentioned inlet 10' and outlet 10".

The grooves 141 can be formed by milling or *skiving.* In case of milling, it is possible, for example, to remove material from the first plate-like body 10A through a rotating tool. In order to optimize the manufacturing time, the costs and number of the obtainable grooves 141, the *skiving* procedure is preferable to milling.

The grooves 141 allow to confine the motion of the cooling fluid and, as said, put in fluid communication the inlet 10' and the outlet 10". With reference to the illustrated example, the grooves further put into fluid communication the inlet manifold 12 and the outlet manifold 13.

Said grooves 141 preferably extend along respective main directions of development d parallel and rectilinear therebetween. The distance between opposite faces of each groove 141 preferably is comprised between 0.5 millimetres (mm) and 2 millimetres (mm).

With reference to a quadrilateral geometry of the plate-like body 10 as mentioned above, the inlet manifold 12 and the outlet manifold 13 (if present) are preferably positioned along opposite peripheral edges of the first plate-like body 10A. Said inlet 12 and outlet 13 manifolds preferably have a main direction of development orthogonal, or substantially orthogonal, to the direction of development d of said grooves 141.

According to the described embodiment, and as it can be seen in Figure 1B, the inlet manifold 12 and the outlet manifold 13 can further be in fluid communication through unidirectional circulation means for the cooling fluid, illustrated by way of example and designated with reference T. However, to the purpose of the present invention, the presence of said unidirectional circulation means T is optional and then it will not be examined in details hereinafter.

With reference now to Figures 2A, 2B and 3A, 3B, once the plurality of grooves 141 has formed, the method of the invention provides to form incisions 2 on the inner surface 141a of one or more of said grooves 141 by laser engraving means. The formation of said incisions 2 and the associated technical effects will be described soon.

Subsequently, the second plate-like body 10B is overlapped and sealingly coupled to the coupling face 101 of the first plate-like body 10A, in such a way that a respective flow channel 14a for the biphasic cooling fluid is defined at each groove 141.

The so-formed flow channels 14a preferably have a hydraulic diameter comprised between 0.5 millimetres (mm) and 2.0 millimetres (mm).

Preferably, the manufacturing method provides that the first body 10A and the covering element 10B were welded therebetween. Based upon the type of coating, the geometry and the material selected for the first and second plate-like body 10A, 10B it is possible to use, for example, a TIG welding process, laser welding, friction welding.

Once overlapped and coupled, the first body 10A and the covering element 10B advantageously form a monolithic body.

In an embodiment variant, and as visible in Figure 1A, the method provides a step of interposing a distributor element 18 of the biphasic fluid flow between the first plate-like body 10A and the covering element 10B. The latter is preferably obtained with a CNC milling machine whereas the distributor element 18 can be implemented through laser cutting. Said distributor element 18 allows a uniform distribution of the fluid in the flow channels 14a and it can be obtained directly on the covering element 10B.

As anticipated above, laser engraving means allows to form incisions 2 inside the grooves 141. Substantially, the use of said laser means melts a, in particular metallic, portion of the internal surface 141a of the grooves 141 and causes a modification of the surface "roughness" in controlled and selected way, to obtain a degree of wettability of the flow channels 14a optimized in function of the operating conditions thereupon the evaporator 100 is intended to operate.

This advantageously allows to improve the heat transfer between the electronic component to be cooled down and the coolant fluid crossing the evaporator 100, without influencing significantly the load losses, by limiting the flow instabilities and moving away the risk of drying phenomena (lack of boiling) at very higher heat flow values with respect to the limit values obtained with the cooling devices implemented according to the known methods.

In order to explain the advantages obtainable with the present manufacturing method, it is suitable to quote hereinafter the main physical phenomena which conditionate the surface wettability in relation to the critical aspects of the heat transfer in cooling systems which operate with a biphasic flow of cooling fluid.

### Nucleated boiling:

The nucleated boiling is one of the heat transfer mechanisms which take place during the phase passage from liquid to vapour. When heat is applied to a solid surface wet by a liquid, the wall temperature generally has to reach a higher value than the liquid saturation temperature. This excess of energy is due to the liquid surface tension. A surface treatment favouring hydrophobicity then reduces the excess of energy for the nucleated boiling with respect to a not treated surface. Hydrophobicity repels the vapour bubbles, by favouring an early detachment from the solid surface. Then, the vapour bubbles are smaller and more frequent on a hydrophobic surface with respect to a not treated surface.

### Thin film evaporation:

The thin film evaporation is one of the heat transfer mechanisms which take place in the biphasic flow, in particular in the microchannels. When the flow model is a vapour cap or elongated bubble model, the microchannel core is occupied by the vapour phase. On the contrary, the liquid phase is an almost static thin pellicle - or film - between vapour and solid surface. The liquid film re-fuels from the liquid element travelling indeed behind the vapour cap or the elongated bubble. The liquid film has a thickness varying together with the vapour bubble, generally larger in the front portion of the bubble, smaller in the middle of the bubble and it can be even absent in the rear portion of the bubble, by creating dry regions. A surface treatment favouring hydrophily helps in spreading the liquid film over the whole surface, by making more uniform the thin film and avoiding dry regions.

### Drying:

The drying of the liquid film from the solid surface generally takes place at determined vapour qualities. When the vapour phase touches the surfaces, the heat exchange coefficient is so low that it can be dangerous for the device which has to be cooled down. In the microchannels, the vapour quality values at which drying takes place can be very low. Hydrophily generally helps in delaying drying with respect to the vapour quality.

### Instability:

The main source of instability in a microchannel evaporator is the so-called reflow. When a vapour bubble grows in its nucleation site, it can be confined along a direction orthogonal to the direction of development d of the microchannel while it expands along the latter. In some cases, the expansion force of the vapour bubble can be sufficiently strong to repel the liquid entering the microchannels towards the inlet, by preventing the re-humidification of the channels' surfaces. A treatment which makes the surface hydrophobic, especially near the inlet of the microchannels, increases the number of the nucleation sites and anticipates the detachment of the vapour bubbles from the surface itself. Therefore, the bubbles can reach greater sizes, by avoiding an abrupt expansion along the development direction of the microchannels. Such instabilities not only take place at local level as described above, but even at system level when the evaporator is applied in complex cooling apparatuses which use passive means (that is radiators) wherein the motion of the cooling fluid is controlled by a significantly lower pushing force with respect to the pump systems.

Substantially, the method of the invention allows to implement a treatment of the internal surface 141a of the flow channels 14a - or microchannels - of a biphasic cooling fluid evaporator 100 which optimizes the heat transfer and reduces the flow instabilities thanks to the fact of obtaining selected hydrophilic and hydrophobic properties on said internal surface 141a.

The laser engraving means includes an electronic and optical apparatus which, for example, can be assembled on a CNC machine. In this way, it is possible to replicate a predetermined incision formation module with a digital file, for example of vectorial type (CAD or the like). The pattern with which the incisions are formed, the laser power, the laser frequency, the laser engraving speed (mm/min), the focal distance (mm), the number of repetitions of laser application to obtain the incisions, are the main variables influencing the wettability of the internal surface 141a of the grooves 141. Such aspects will be treated more in details with reference to the experimental results shown in appendix.

Going back to Figures 2A, 2B and 3A, 3B the incisions preferably are formed according to a direction orthogonal v or parallel p to the direction of development d of the respective groove 141. However, different patterns of incisions can be obtained, for example a combination of parallel and orthogonal, or honeycomb lines.

In particular, said incisions 2 are formed on a portion of said internal surface 141a opposite to the face of the covering element 10B which, in use of the evaporator 100, is facing towards the inside of the respective flow channel 14a. The distance between opposite faces of one or more incisions 2 preferably is equal to 80 micrometres. The depth of the incisions preferably is equal to the distance between the opposite faces of the incision 2 itself.

In not illustrated embodiments, the orientation of the incisions 2 varies along the direction of development d of the respective groove 141. Then, it is possible to form different patterns of incisions 2 inside the same groove 141, for example, in function of the axial distance from the ends 141', 141" of the latter. For example, a grid or a matrix of incisions formed at the end 141' wherein the biphasic fluid enters the flow channel 14a promotes hydrophobicity, increases the nucleation sites and prevents instabilities. A pattern of incisions parallel to the direction of development d of the groove formed at the end 141" wherein the biphasic fluid exits the flow channel 14a, favours crossing since it promotes hydrophily, prevents drying and improves evaporation of the thin film.

Only apparently a laser incision 2, the distance thereof between opposite faces - or opening width - is calibrated on the critical fluid nucleation radius, confers the internal surface 141a of the groove 141 hydrophobic properties, independently from the orientation of the incision 2 itself.

In fact, on the bottom 2a of the incision 2 a capillarity effect can be created, considering that there is a liquid-vapour interface. In presence of an orientation of the incisions 2 orthogonal v to the flow channels 14a, the liquid motion by capillarity is not created, since along the incision 2 there is no curvature variation in the liquid-vapour interface. On the contrary, in presence of an orientation of the incisions 2 parallel p to the flow channels 14a, the curvature of the liquid-vapour interface in a point along the flow channel 14a is different from the curvature of the liquid-vapour interface in a different point. The curvature variation of the interface along an incision 2 oriented parallelly to the direction of development d of the groove 141 can establish a liquid motion by capillarity in the flow channel 14a, thus emulating a hydrophilic effect.

According to a preferred embodiment, the method provides to form incisions extending continuously between the ends 141', 141" of the groove 141.

### Experimental Data

The physical concept of the boiling critical radius of the nucleate is illustrated preliminarily to explain the way in which the incisions obtained through the laser means can influence the heat treatment in a biphasic fluid microchannel evaporator.

For a stagnant liquid in contact with a hot surface, a vapour bubble is generated on a surface cavity of a wall only when the wall temperature is higher than the fluid saturation temperature. The temperature difference between wall and fluid triggering a vapour bubble depends upon the cavity radius, upon the fluid density and upon the surface tension, upon the latent heat of vaporization and upon the heat flow.

Figure 4 shows three courses of the boiling critical radius of the nucleate for the coolant R1234ze(E) in function of the temperature difference (in Kelvin) between wall and fluid (T_{wall}-Tₛₐₜ) calculated with an empiric correlation. Said courses were obtained with respect to different values of the surface properties of the wall of flow channel 14a, in particular for angles of surface cavities equal to 30°, 60° and 90°.

The graph of Figure 4 shows that when the surface cavity radius of the wall of the flow channel 14a decreases, the temperature difference required to trigger a vapour bubble increases.

The surface cavity radius mentioned above is proportional to the roughness of the internal surface 141a of the flow channel 14a and then it is clear that, when the surface roughness of a microchannel 14a decreases, a high temperature difference is required to generate the vapour bubble. Without the laser treatment provided by the invention, and then without the formation of incisions 2, the roughness of the internal surface of the microchannels 14a generally is in the order of the micrometre units. For this reason, the method of the invention selected a set of operating parameters of the laser engraving means in order to form incisions 2 having a width between opposite faces equal to about 80 micrometres (µm). In this way, roughness values of the internal surface of the microchannels 2 of at least a greater order of magnitude with respect to the roughness values obtainable with the same surface in absence of incisions are conferred.

Preferably, the incisions 2 were formed by using the following operating parameters of the laser means: an incision speed equal to approximately 200 millimetres/minute (mm/min), the use of 90% of power of a laser generator having power of 30 W, a focal distance of 49 millimetres (mm) and a number of repetitions equal to 3 of application of the laser means for each incision 2.

Figure 5 illustrates the experimental data demonstrating the advantageous effect of the laser engraving technology on the heat exchange coefficient of a microchannel evaporator 100 having the features of the above-described embodiments.

In particular, Figure 5 shows the course of three boiling curves of the cooling fluid (that is of refrigeration power expressed in Watt) crossing an evaporator 100 wherein the incisions 2, respectively, are absent (curve designated "No Laser"), formed parallelly to the direction of development d of the grooves 141 (curve designated "Laser 0°"), formed orthogonally to the direction of development d of the grooves 141 (curve designated "Laser 90°"). Each curve is obtained in function of the difference (Tₑᵥₐₚₒᵣₐₜₒᵣ - Tₛₐₜ) in Kelvin (K) degrees between the temperature of the contact external surface 11 of the evaporator 100 with the electronic component to be cooled down and the temperature of the biphasic cooling fluid.

As it can be seen, the surface treatment conferred by the laser means has a meaningful advantageous effect on the global effectiveness of the heat transfer, especially for medium-low heat loads. By way of numeral example, for values of heat load equal to 300 W, the laser treatments show approximately 3 or 4 Kelvin degrees less than the configuration without treatment. After 300 W, both curves corresponding to the presence of incisions 2 on the surface of the flow channels 14a, tend to have a flatter slope, by showing that the advantageous effect of the laser treatment tends to decrease. This effect is an indicator of localized points of absence of liquid in wall and, then, it is probable that with the laser treatment a dominant hydrophobic property of the internal surface 141a of the flow channels 14a was obtained.

The present invention has been sofar described with reference to preferred embodiments. It is to be meant that other embodiments belonging to the same inventive core may exist, as defined by the protective scope of the herebelow reported claims.

## Claims

1. A method of manufacturing an evaporator (100) of the microchannel type and suitable for cooling down electronic components, which method comprises the steps of:
- providing a first (10A) and a second (10B) plate-like body, said second plate-like body (10B) comprising an inlet (10') and an outlet (10") for a biphasic cooling fluid in/from the evaporator (100),
- forming on a coupling face (101) of said first plate-like body (10A) a plurality of grooves (141) so as to put in fluid communication said inlet (10') and said outlet (10"),
- forming incisions (2) on the inner surface (141a) of one or more grooves (141) of said plurality of grooves,
- overlapping and fluidic seal coupling said second plate-like body (10B) to said coupling face (101) in such a way that a respective flow channel (14a) for the biphasic cooling fluid is defined at each groove (141), the method being **characterized in that** the one or more grooves of said plurality of grooves (141) are formed by means of laser engraving, and **in that** the incisions (2) extend between the ends of the groove (141).

2. The manufacturing method according to claim 1, wherein said incisions (2) are formed according to a direction orthogonal (v) or parallel (p) to a direction of development (d) of the respective groove (141).

3. The manufacturing method according to claim 1 or 2, wherein the orientation of the incisions (2) varies along the direction of development (d) of the respective groove (141).

4. The manufacturing method according to any one of the preceding claims, wherein the incisions (2) are formed on a portion of said internal surface (141a) opposite to the face of said second plate-like body (10B) which, in use of the evaporator, faces towards the inside of the respective flow channel (14a).

5. The manufacturing method according to any one of the preceding claims, wherein the distance between opposite faces of each groove (141) is comprised between 0.5 millimetres and 2 millimetres.

6. The manufacturing method according to any one of the preceding claims, wherein the distance between opposite faces of one or more incisions (2) is equal to 80 micrometres.

7. The manufacturing method according to any one of the preceding claims, wherein said first (10A) and second (10B) plate-like body made from metallic material, in particular aluminium, are provided.

8. The manufacturing method according to any one of the preceding claims, wherein said first (10A) and second (10B) plate-like body are coupled to form a monolithic body.

9. The manufacturing method according to any one of the preceding claims and further comprising a step of interposing a distributor element (18) of the biphasic fluid flow between said first (10A) and second (10B) plate-like body.

10. The manufacturing method according to the preceding claim, wherein said distributor element (18) is obtained in said second plate-like body (10B).

11. The manufacturing method according to any one of the preceding claims, wherein the plurality of grooves (141) are formed by milling or skiving.

12. The manufacturing method according to any one of the preceding claims, wherein the grooves (141) of said plurality are parallel to each other and rectilinear.

13. An evaporator (100) of the microchannel type and suitable for cooling down electronic components through a biphasic fluid, said evaporator (100) being obtained according to a manufacturing method according to any one of the preceding claims and comprising flow channels (14a) for the biphasic fluid which have on their internal surface (141a) incisions (2) obtained with laser engraving means.

## Patentansprüche

1. Verfahren zum Herstellen eines Verdampfers (100) vom Mikrokanaltyp und geeignet zum Abkühlen elektronischer Komponenten, wobei das Verfahren die Schritte umfasst:
- Bereitstellen eines ersten (10A) und eines zweiten (10B) plattenartigen Körpers, der zweite plattenartige Körper (10B) umfassend einen Einlass (10') und einen Auslass (10") für ein zweiphasiges Kühlfluid in/aus dem Verdampfer (100),
- Ausbilden, auf einer Kupplungsfläche (101) des ersten plattenartigen Körpers (10A), einer Vielzahl von Rillen (141), um den Einlass (10') und den Auslass (10") in Fluidverbindung zu bringen,
- Ausbilden von Einschnitten (2) auf der Innenoberfläche (141a) einer oder mehrerer Rillen (141) der Vielzahl von Rillen,
- Überlappendes und fluiddichtes Koppeln des zweiten plattenartigen Körpers (10B) mit der Koppelfläche (101) auf eine Weise, dass ein jeweiliger Strömungskanal (14a) für das zweiphasige Kühlfluid an jeder Nut (141) definiert wird, wobei das Verfahren **dadurch gekennzeichnet ist, dass** die eine oder mehrere Rillen der Vielzahl von Rillen (141) mittels Lasergravur ausgebildet sind, und dass sich die Einschnitte (2) zwischen den Enden der Rille (141) erstrecken.

2. Herstellungsverfahren nach Anspruch 1, wobei die Einschnitte (2) in einer Richtung orthogonal (v) oder parallel (p) zu einer Verlaufsrichtung (d) der jeweiligen Nut (141) ausgebildet werden.

3. Herstellungsverfahren nach Anspruch 1 oder 2, wobei die Ausrichtung der Einschnitte (2) entlang der Verlaufsrichtung (d) der jeweiligen Rille (141) variiert.

4. Herstellungsverfahren nach einem der vorstehenden Ansprüche, wobei die Einschnitte (2) an einem Abschnitt der Innenoberfläche (141a) ausgebildet werden, der der Fläche des zweiten plattenförmigen Körpers (10B) gegenüberliegt, die bei Verwendung des Verdampfers zu der Innenseite des jeweiligen Strömungskanals (14a) hin weist.

5. Herstellungsverfahren nach einem der vorstehenden Ansprüche, wobei der Abstand zwischen gegenüberliegenden Flächen jeder Rille (141) zwischen 0,5 Millimeter und 2 Millimeter liegt.

6. Herstellungsverfahren nach einem der vorstehenden Ansprüche, wobei der Abstand zwischen gegenüberliegenden Flächen eines oder mehrerer Einschnitte (2) gleich 80 Mikrometer ist.

7. Herstellungsverfahren nach einem der vorstehenden Ansprüche, wobei der erste (10A) und der zweite (10B) plattenartige Körper, gefertigt aus metallischem Material, insbesondere Aluminium, bereitgestellt sind.

8. Herstellungsverfahren nach einem der vorstehenden Ansprüche, wobei der erste (10A) und der zweite (10B) plattenartige Körper gekoppelt werden, um einen monolithischen Körper auszubilden.

9. Herstellungsverfahren nach einem der vorstehenden Ansprüche, ferner umfassend einen Schritt des Einfügens eines Verteilerelements (18) für den zweiphasigen Fluidstrom zwischen dem ersten (10A) und zweiten (10B) plattenartigen Körper.

10. Herstellungsverfahren nach dem vorstehenden Anspruch, wobei das Verteilerelement (18) in dem zweiten plattenförmigen Körper (10B) erhalten wird.

11. Herstellungsverfahren nach einem der vorstehenden Ansprüche, wobei die Vielzahl von Rillen (141) durch Fräsen oder Schälen ausgebildet wird.

12. Herstellungsverfahren nach einem der vorstehenden Ansprüche, wobei die Rillen (141) der Vielzahl parallel zueinander und geradlinig sind.

13. Verdampfer (100) vom Mikrokanaltyp, geeignet zum Kühlen elektronischer Komponenten durch ein zweiphasiges Fluid, wobei der Verdampfer (100) gemäß einem Herstellungsverfahren nach einem der vorstehenden Ansprüche erhalten wird und umfassend Strömungskanäle (14a) für das zweiphasige Fluid, die auf ihrer Innenoberfläche (141a) Einschnitte (2) aufweisen, die mit Lasergravurmitteln erhalten werden.

## Revendications

1. Procédé de fabrication d'un évaporateur (100) du type à microcanaux et apte au refroidissement de composants électroniques, lequel procédé comprend les étapes suivantes :
- la fourniture d'un premier (10A) et un second (10B) corps en forme de plaque, ledit second corps en forme de plaque (10B) comprenant une entrée (10') et une sortie (10") pour un fluide de refroidissement biphasique dans/depuis l'évaporateur (100),
- la formation, sur une face d'accouplement (101) dudit premier corps en forme de plaque (10A), d'une pluralité de rainures (141) de manière à mettre en communication fluidique ladite entrée (10') et ladite sortie (10"),
- la formation des incisions (2) sur la surface intérieure (141a) d'une ou plusieurs rainures (141) de ladite pluralité de rainures,
- le chevauchement et le scellement fluidique reliant ledit second corps en forme de plaque (10B) à ladite face d'accouplement (101) de telle sorte qu'un canal d'écoulement respectif (14a) pour le fluide de refroidissement biphasique soit défini au niveau de chaque rainure (141), le procédé étant **caractérisé en ce que** la ou les rainures de ladite pluralité de rainures (141) sont formées au moyen d'une gravure au laser, et **en ce que** les incisions (2) s'étendent entre les extrémités de la rainure (141).

2. Procédé de fabrication selon la revendication 1, dans lequel lesdites incisions (2) sont formées selon une direction orthogonale (v) ou parallèle (p) à une direction de développement (d) de la rainure respective (141).

3. Procédé de fabrication selon la revendication 1 ou 2, dans lequel l'orientation des incisions (2) varie le long de la direction de développement (d) de la rainure respective (141).

4. Procédé de fabrication selon l'une quelconque des revendications précédentes, dans lequel les incisions (2) sont formées sur une partie de ladite surface interne (141a) opposée à la face dudit second corps en forme de plaque (10B) qui, lors de l'utilisation de l'évaporateur, est orientée vers l'intérieur du canal d'écoulement respectif (14a).

5. Procédé de fabrication selon l'une quelconque des revendications précédentes, dans lequel la distance entre les faces opposées de chaque rainure (141) est comprise entre 0,5 millimètre et 2 millimètres.

6. Procédé de fabrication selon l'une quelconque des revendications précédentes, dans lequel la distance entre les faces opposées d'une ou plusieurs incisions (2) est égale à 80 micromètres.

7. Procédé de fabrication selon l'une quelconque des revendications précédentes, dans lequel le premier (10A) et le second (10B) corps en forme de plaque en matériau métallique, en particulier en aluminium, sont fournis.

8. Procédé de fabrication selon l'une quelconque des revendications précédentes, dans lequel le premier (10A) et le second (10B) corps en forme de plaque sont accouplés pour former un corps monolithique.

9. Procédé de fabrication selon l'une quelconque des revendications précédentes, comprenant en outre une étape consistant à interposer un élément distributeur (18) du flux de fluide biphasique entre le premier (10A) et le second (10B) corps en forme de plaque.

10. Procédé de fabrication selon la revendication précédente, dans lequel l'élément distributeur (18) est obtenu dans le second corps en forme de plaque (10B).

11. Procédé de fabrication selon l'une quelconque des revendications précédentes, dans lequel la pluralité de rainures (141) est formée par fraisage ou écroutage.

12. Procédé de fabrication selon l'une quelconque des revendications précédentes, dans lequel les rainures (141) de ladite pluralité sont parallèles entre elles et rectilignes.

13. Évaporateur (100) du type à microcanaux et apte à refroidir des composants électroniques par l'intermédiaire d'un fluide biphasique, ledit évaporateur (100) étant obtenu selon un procédé de fabrication selon l'une quelconque des revendications précédentes et comprenant des canaux d'écoulement (14a) du fluide biphasique présentant sur leur surface interne (141a) des incisions (2) obtenues à l'aide de moyens de gravure laser.
